(19) Europäisches Patentamt
European Patent Office
Office européen des brevets

(11) EP 3 198 698 B1

(12) # EUROPÄISCHE PATENTSCHRIFT

(45) Veröffentlichungstag und Bekanntmachung des Hinweises auf die Patenterteilung:
**12.08.2020 Patentblatt 2020/33**

(21) Anmeldenummer: **14801988.8**

(22) Anmeldetag: **14.11.2014**

(51) Int Cl.:
***H02H 7/045*** *(2006.01)*

(86) Internationale Anmeldenummer:
**PCT/EP2014/074610**

(87) Internationale Veröffentlichungsnummer:
**WO 2016/074742 (19.05.2016 Gazette 2016/20)**

(54) **DIFFERENTIALSCHUTZVERFAHREN UND DIFFERENTIALSCHUTZGERÄT ZUM DURCHFÜHREN EINES DIFFERENTIALSCHUTZVERFAHRENS**

DIFFERENTIAL PROTECTION METHOD AND DIFFERENTIAL PROTECTION DEVICE FOR PERFORMING A DIFFERENTIAL PROTECTION METHOD

PROCÉDÉ DE PROTECTION DE DIFFÉRENTIEL ET APPAREIL DE PROTECTION DE DIFFÉRENTIEL PERMETTANT DE METTRE EN OEUVRE UN PROCÉDÉ DE PROTECTION DE DIFFÉRENTIEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**02.08.2017 Patentblatt 2017/31**

(73) Patentinhaber: **Siemens Aktiengesellschaft**
**80333 München (DE)**

(72) Erfinder: **MIESKE, Frank**
**13053 Berlin (DE)**

(56) Entgegenhaltungen:
**DE-A1- 10 261 848 DE-C1- 4 416 048**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft ein Differentialschutzverfahren zum Erzeugen eines Fehlersignals, bei dem an mindestens zwei unterschiedlichen Messstellen eines mehrphasigen Transformators für jede Phase jeweils Strommesswerte gemessen werden, mit den Strommesswerten für jede Phase Differenzstromwerte und Stabilisierungswerte gebildet werden und das Fehlersignal erzeugt wird, wenn im Rahmen einer Auslösebereichsprüfung festgestellt wird, dass ein unter Heranziehung eines der Differenzstromwerte und dem jeweils zugehörigen Stabilisierungswert gebildetes Messwertpaar zumindest einer der Phasen in einem vorgegebenen Auslösebereich liegt. Die Erfindung bezieht sich auch auf ein entsprechendes elektrisches Differentialschutzgerät zur Durchführung eines Differentialschutzverfahrens.

Differentialschutzgeräte zur Durchführung eines Differentialschutzverfahrens werden unter anderem zur Überwachung von mehrphasigen, z.B. dreiphasigen, Transformatoren in Energieversorgungsnetzen eingesetzt. Dabei wird an mindestens zwei unterschiedlichen Messstellen des überwachten Transformators, bei einem zweiseitigen Transformator üblicherweise auf beiden Seiten des Transformators, für jede Phase der an den Messstellen fließende Strom erfasst und in Form von Strommesswerten dem Schutzgerät zugeführt. Das Schutzgerät bildet durch vorzeichenrichtige Addition für jede Phase aus den Strommesswerten Differenzstromwerte, die zur Beurteilung der Betriebssituation des überwachten Transformators herangezogen werden.

Da ein Transformator selbst eine Veränderung der Amplitude und des Phasenwinkels des durch ihn hindurchfließenden Stroms bewirkt, müssen die Strommesswerte mindestens einer Seite vor der Differenzstromwertbildung hinsichtlich ihrer Amplitude und ihres Phasenwinkels angepasst werden, um miteinander vergleichbare Strommesswerte für beide Seiten des Transformators zu erhalten. Diese Anpassung erfolgt hinsichtlich der Amplitude üblicherweise aus dem bekannten Übersetzungsverhältnis des Transformators. Hinsichtlich des Phasenwinkels findet ebenfalls eine Anpassung durch Verwendung entsprechender Anpassungsmatrizen statt. Die jeweilige Anpassungsmatrix leitet sich beispielsweise aus der Schaltgruppe des Transformators ab und kann z.B. aus entsprechenden Tabellenwerken entnommen werden. Es ist darüber hinaus auch möglich, eine automatische Phasenwinkelanpassung, z.B. durch Messung des Phasenwinkelunterschieds zwischen den Strommesswerten an den unterschiedlichen Messstellen des Transformators, durchzuführen. Die Amplitudenanpassung sowie die Phasenwinkelanpassung sind dem Fachmann hinlänglich bekannt und werden daher an dieser Stelle nicht eingehender erläutert.

Da bei einem Transformator mit geerdetem Sternpunkt auf einer Seite des Transformators ein Nullstrom entstehen und die Differentialschutzmessung beeinflussen kann, wird üblicherweise eine zusätzliche Korrektur einer Nullstromkomponente der Strommesswerte des Transformators durchgeführt. Hierfür kann entweder ein gemessener Sternpunktstrom oder ein aus den Strommesswerten der einzelnen Phasen berechneter Nullstrom verwendet werden.

Nach entsprechender Anpassung der Amplituden und Phasenwinkel der Strommesswerte sowie einer Nullstromkorrektur wird die Differenzstromwertbildung durchgeführt.

Im fehlerfreien Fall liegen die Differenzstromwerte in einem Bereich nahe Null, da hierbei - vereinfacht gesprochen - der in den Transformator hinein fließende Strom auch wieder aus ihm heraus fließt. Ergeben sich hingegen Differenzstromwerte, die deutlich von Null abweichen, so lassen diese auf einen fehlerbehafteten Betriebszustand, z. B. einen internen Kurzschluss, schließen, so dass der Fehlerstrom durch Öffnen von den Transformator begrenzenden Schalteinrichtungen, z.B. Leistungsschaltern, unterbrochen werden muss. Hierfür erzeugt das Schutzgerät ein entsprechendes Fehlersignal, das zur Erzeugung eines Auslösesignals verwendet wird, um die Schalter zum Öffnen ihrer Schaltkontakte zu veranlassen.

Da in der Praxis normalerweise keine idealen Verhältnisse, z.B. ein Differenzstrom im fehlerfreien Fall mit genau dem Wert Null, vorliegen, muss für den Differenzstrom ein geeigneter Vergleichswert gefunden werden. Hierfür wird der sogenannte Stabilisierungswert verwendet, der beispielsweise durch Summenbildung der Beträge der jeweiligen Strommesswerte berechnet wird. Andere Möglichkeiten zur Berechnung von Stabilisierungswerten beim Transformatordifferentialschutz sind eine Differenzbildung der Beträge der jeweiligen Strommesswerte oder die Auswahl des Maximalwertes aus den Beträgen der jeweiligen Strommesswerte.

Trägt man einen Differenzstromwert und einen zugehörigen Stabilisierungswert in einem Auslösediagramm auf, so liegt das jeweilige Messwertpaar entweder innerhalb oder außerhalb eines festgelegten Auslösebereichs, so dass durch Auswertung der Lage des Messwertpaares auf die Bildung des Fehlersignals geschlossen werden kann: das Fehlersignal wird dann erzeugt, wenn das Messwertpaar innerhalb des vorgegebenen Auslösebereichs liegt.

Probleme ergeben sich hierbei beispielsweise dann, wenn einer oder mehrere der verwendeten Stromwandler, insbesondere bei stromstarken externen, also außerhalb des überwachten Transformators liegenden Fehlern, in Sättigung gehen und der von ihnen abgegebene sekundäre Stromverlauf keine korrekte Abbildung des primärseitigen Stromverlaufs darstellt. In solchen Fällen kann fälschlicherweise ein signifikanter Differenzstrom erkannt und damit ein Fehlersignal erzeugt werden.

Ein Differentialschutzverfahren der eingangs genannten Art ist beispielsweise aus der WO 2008/025309 A1 bekannt. Bei dem bekannten Differentialschutzgerät werden die an den unterschiedlichen Messstellen einer Komponente eines Energieversorgungsnetzes, z.B. eines Transformators, erfassten Stromverläufe hinsichtlich einer Ähnlichkeit überprüft und die Empfindlichkeit der Auslösung des Differentialschutzes entsprechend der erkannten Ähnlichkeit angepasst. Auf diese Weise kann erreicht werden, dass bei - z.B. durch Wandlersättigung - unähnlichen Stromverläufen die Empfindlichkeit des Differentialschutzgeräts entsprechend herabgesetzt wird, um nicht ungewollt ein Fehlersignal abzugeben.

Aus der WO 2014/079511 A1 ist außerdem ein Differentialschutzverfahren bekannt, bei dem anhand von wenigen erfassten Strommesswerten durch Abschätzung prognostizierte zukünftige Werte von Differenzstromwerten und Stabilisierungsstromwerten ermittelt werden und zur Entscheidung über die Erzeugung eines Fehlersignals die Lage der jeweiligen Messwertpaare in einem Auslösebereich geprüft wird.

Der Erfindung liegt die Aufgabe zugrunde, ein Verfahren bzw. Differentialschutzgerät zur Überwachung eines mehrphasigen Transformators anzugeben, um selektiv und zuverlässig einen externen Fehler von einem internen Fehler unterscheiden zu können.

Hinsichtlich des Verfahrens wird diese Aufgabe durch ein Differentialschutzverfahren nach Anspruch 1 gelöst, bei dem der Transformator einen geerdeten Sternpunkt aufweist und zur Bildung der Stabilisierungswerte ein durch den Sternpunkt fließender Nullsystemstrom herangezogen wird, wobei als jeweiliger Stabilisierungswert ein Maximalwert aus den an den jeweiligen Messstellen gebildeten Strommesswerten sowie den auf den jeweiligen Seiten des Transformators fließenden Nullsystemströmen verwendet wird.

Beim Durchführen eines Differentialschutzverfahrens für Transformatoren mit geerdetem Sternpunkt hat es sich nämlich herausgestellt, dass durch eine in diesem Fall durchgeführte Nullstromkorrektur die Strommesswerte und damit auch die Stabilisierungswerte für diejenige Seite des Transformators, auf der die Nullstromkorrektur durchgeführt wird, zu Null wird. Damit berücksichtigt der Stabilisierungsstrom in diesem Fall nur den auf den Seiten des Transformators, die keinen geerdeten Sternpunkt aufweisen, fließenden Laststrom, der im Leerlauf des Transformators auch Null betragen kann, so dass in diesem Fall - aufgrund der fehlenden Stabilisierung des Differentialschutzverfahrens - insbesondere bei stromstarken externen Fehlern und/oder vorliegender Wandlersättigung - die Gefahr einer Fehlauslösung bestünde. Durch die Einbeziehung des Nullsystemstroms in die Berechnung der Stabilisierungswerte kann das Risiko einer Fehlauslösung für solche Fälle jedoch signifikant reduziert werden, da hierbei aufgrund des im Fehlerfall vergleichsweise hohen Nullsystemstroms immer ausreichend große Stabilisierungswerte gebildet werden.

Erfindungsgemäß ist vorgesehen, dass als jeweiliger Stabilisierungswert ein Maximalwert aus den an den jeweiligen Messstellen gebildeten Strommesswerten sowie den auf den jeweiligen Seiten des Transformators fließenden Nullsystemströmen verwendet wird.

Der Wert des Nullsystemstroms fließt dabei direkt in die Höhe des Stabilisierungswertes ein.

Gemäß einer vorteilhaften Ausführungsform des erfindungsgemäßen Verfahrens ist vorgesehen, dass der Nullsystemstrom durch Messung eines durch den Sternpunkt fließenden Stroms ermittelt wird.

Diese Ausführungsform eignet sich dann, wenn der Sternpunktstrom durch einen eigenen Stromwandler erfasst werden kann. Eine Möglichkeit zur Messung des Sternpunktstroms ist beispielsweise aus der DE4416048C1 bekannt.

Alternativ zu dieser Ausführungsform kann gemäß einer anderen vorteilhaften Ausführungsform des erfindungsgemäßen Verfahrens auch vorgesehen sein, dass der Nullsystemstrom rechnerisch aus den für die einzelnen Phasen erfassten Strommesswerten ermittelt wird.

Diese Berechnung kann anhand der Strommesswerte $I_A$, $I_B$, $I_C$ auf derjenigen Seite des Transformators, die den geerdeten Sternpunkt aufweist, wie folgt stattfinden und ist dem Fachmann als "Nullstromeliminierung" bekannt:

$$3I_0 = I_A + I_B + I_C.$$

In diesem Fall wird kein separater Stromwandler zur Messung eines durch den Sternpunkt fließenden Stroms benötigt.

Die oben genannte Aufgabe wird auch durch ein elektrisches Differentialschutzgerät zur Bildung eines Fehlersignals nach Anspruch 4 gelöst, mit Anschlüssen zum unmittelbaren oder mittelbaren Anschluss an zumindest zwei unterschiedliche Messstellen einer Komponente eines elektrischen Energieversorgungsnetzes, und mit einer Auswerteinrichtung, die dazu eingerichtet ist, mit an den Messstellen erfassten Strommesswerten Differenzstromwerte und Stabilisierungswerte zu bilden und ein Fehlersignal zu erzeugen, wenn ein unter Heranziehung eines der Differenzstromwerte und dem jeweils zugehörigen Stabilisierungswert gebildetes Messwertpaar in einem vorgegebenen Auslösebereich liegt.

Erfindungsgemäß ist vorgesehen, dass der Transformator einen geerdeten Sternpunkt aufweist und die Auswerteinrichtung dazu eingerichtet ist, zur Bildung der Stabilisierungswerte einen durch den Sternpunkt fließenden Nullsystemstrom heranzuziehen, wobei die Auswerteinrichtung dazu eingerichtet ist, den jeweiligen Stabilisierungswert durch Maximalwertermittlung aus den an den jeweiligen Messstellen gebildeten Strommesswerten sowie den auf den jeweiligen Seiten des Transformators fließenden Nullsystemströmen zu ermitteln.

Erfindungsgemäß ist vorgesehen, dass die Auswerteinrichtung dazu eingerichtet ist, den jeweiligen Stabilisierungswert durch Maximalwertermittlung aus den an den jeweiligen Messstellen gebildeten Strommesswerten sowie den auf den jeweiligen Seiten des Transformators fließenden Nullsystemströmen zu ermitteln.

Hinsichtlich der Erfassung des Nullsystemstroms kann zudem vorgesehen sein, dass das Schutzgerät einen Anschluss zum unmittelbaren oder mittelbaren Anschluss an einer Sternpunktstrommessstelle umfasst und die Auswerteinrichtung dazu eingerichtet ist, den Nullsystemstrom durch Messung eines durch den Sternpunkt fließenden Stroms zu ermitteln, oder dass die Auswerteinrichtung dazu eingerichtet ist, den Nullsystemstrom rechnerisch aus den für die einzelnen Phasen erfassten Strommesswerten zu ermitteln.

Hinsichtlich des erfindungsgemäßen Differentialschutzgerätes gelten alle zu dem erfindungsgemäßen Differentialschutzverfahren voranstehend und nachfolgend gemachten Ausführungen und umgekehrt in entsprechender Weise, insbesondere ist das erfindungsgemäße Differentialschutzgerät zur Durchführung des erfindungsgemäßen Differentialschutzverfahrens in jeder beliebigen Ausführungsform oder einer Kombination beliebiger Ausführungsformen eingerichtet. Auch hinsichtlich der Vorteile des erfindungsgemäßen Differentialschutzgerätes wird auf die zu dem erfindungsgemäßen Differentialschutzverfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Differentialschutzverfahrens und des erfindungsgemäßen Schutzgerätes in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen

| | |
|---|---|
| Figur 1 | eine schematische Ansicht eines einen Transformator überwachenden Differentialschutzgerätes; und |
| Figuren 2-4 | Auslösediagramme mit beispielhaft eingetragenen Messwertpaaren von Differenzstromwerten und Stabilisierungswerten. |

Im Rahmen des Ausführungsbeispiels wird aus Gründen der vereinfachten Darstellung von einem Transformator mit zwei Seiten ausgegangen. Zur Anwendung der Erfindung auf Transformatoren mit mehr als zwei Seiten muss die beschriebene Vorgehensweise für alle übrigen Seiten in entsprechender Weise durchgeführt werden.

Figur 1 zeigt in schematischer Ansicht einen Ausschnitt eines dreiphasigen (Phasenleiter A, B, C) elektrischen Energieversorgungssystems mit einem zweiseitigen Transformator 10 in Stern-Dreieckschaltung mit auf der Oberspannungsseite 10a geerdetem Sternpunkt 14. Der Transformator 10 wird mittels eines Differentialschutzgerätes 11 hinsichtlich des Auftretens interner Fehler (z.B. Kurzschlüsse, Erdschlüsse, Windungsfehler) überwacht. Hierzu werden an einer ersten Messstelle M1 auf der Oberspannungsseite 10a des Transformators 10 mittels Strommesseinrichtungen (z.B. induktiven Wandlern oder sogenannten nicht-konventionellen Wandlern) Strommesswerte $I_A$, $I_B$, $I_C$ erfasst und entsprechenden Anschlüssen einer Messwerterfassungseinrichtung 12 des Differentialschutzgerätes 11 zugeführt. In entsprechender Weise werden an einer zweiten Messstelle M2 auf einer Niederspannungsseite 10b des Transformators 10 mittels Strommesseinrichtungen Strommesswerte $I_a$, $I_b$, $I_c$ erfasst und entsprechenden weiteren Anschlüssen der Messwerterfassungseinrichtung 12 des Differentialschutzgerätes 11 zugeführt. Die Strommesswerte $I_A$, $I_B$, $I_C$, $I_a$, $I_b$, $I_c$ können dabei in analoger oder digitaler Form zur Messwerterfassungseinrichtung 12 übertragen werden. Sofern die Strommesswerte $I_A$, $I_B$, $I_C$, $I_a$, $I_b$, $I_c$ als analoge Messwerte an der Messwerterfassungseinrichtung 12 anliegen, werden sie dort ggf. gefiltert und einer A/D-Wandlung unterzogen. Andernfalls findet eine Filterung und A/D-Wandlung bereits außerhalb der Messwerterfassungseinrichtung 12 statt, beispielsweise mittels einer sogenannten Remote Terminal Unit oder einer Merging Unit. Die digitalisierten Messwerte werden in diesem Fall über einen Prozessbus zum Differentialschutzgerät 11 übertragen.

Die Messwerterfassungseinrichtung 12 ist ausgangsseitig mit einer Auswerteinrichtung 13 des Differentialschutzgerätes 11 verbunden, bei der es sich beispielsweise um einen entsprechend ausgebildeten Hardwarerechenbaustein (ASIC, FPGA), eine zentrale Mikroprozessorbaugruppe, einen Digitalen Signalprozessor (DSP) oder eine Kombination aus den genannten Einrichtungen handeln kann. Die Auswerteinrichtung 13 ist durch software- und/oder hardwarebestimmte Programmierung dazu eingerichtet, unter Nutzung der Strommesswerte von beiden Seiten des Transformators 10 ein Differentialschutzverfahren durchzuführen, um etwaige interne Fehler erkennen und abschalten zu können.

Da bei der Transformation von Strom und Spannung durch den Transformator 10 im Vergleich zu den oberspannungsseitig anliegenden Größen Veränderungen von Amplitude und Phasenwinkel des niederspannungsseitig abgegebenen Stroms stattfinden, werden für die Durchführung des Differentialschutzverfahrens die Strommesswerte hinsichtlich ihrer Amplitude und ihres Phasenwinkels zunächst angepasst. Nachfolgend wird eine solche Anpassung hinsichtlich der Ströme $I_a$, $I_b$, $I_c$ auf der Niederspannungsseite 10b des Transformators 10 beschrieben, es wäre jedoch alternativ oder zusätzlich ebenfalls möglich, die Strommesswerte der Oberspannungsseite 10a anzupassen.

Zur amplitudenbezogenen Anpassung werden die Strommesswerte $I_a$, $I_b$, $I_c$ unter Verwendung des Transformatorübersetzungsverhältnisses n angepasst. Dieses gibt das Verhältnis der Anzahl der Windungen der Oberspannungswicklung zu denjenigen der Unterspannungswicklung an und bestimmt die amplitudenbezogene Veränderung des Stroms während des Transformationsprozesses. Außerdem wird eine Anpassung des Phasenwinkels zwischen der Ober- und der Unterspanungsseite durchgeführt. Die Phasenwinkelveränderung resultiert im Wesentlichen aus der konstruktiv vorgegebenen Schaltgruppe und der Stellung etwaiger Stufenschalter. Diese Anpassungen sind hinlänglich bekannt und werden daher an dieser Stelle nicht weiter beschrieben. Ausgangsseitig liegen nach der Amplituden- und Phasenwinkelanpassung angepasste Strommesswerte $I'_a$, $I'_b$, $I'_c$ vor.

Auf der Oberspannungsseite 10a des Transformators 10 kann aufgrund der Erdung des Sternpunktes 14 eine Nullsystemstromkomponente $I_0$ auftreten. Diese wird vor der Durchführung des Differentialschutzverfahrens durch entsprechende Korrektur ausgeglichen. Die nachfolgende Gleichung stellt die Nullsystemstromkorrektur für die auf der Oberspannungsseite 10a erfassten Strommesswerte $I_A$, $I_B$, $I_C$ dar:

$$\begin{pmatrix} \hat{I}_A \\ \hat{I}_B \\ \hat{I}_C \end{pmatrix} = \begin{pmatrix} 1 & 0 & 0 \\ 0 & 1 & 0 \\ 0 & 0 & 1 \end{pmatrix} \cdot \begin{pmatrix} I_A \\ I_B \\ I_C \end{pmatrix} + \begin{pmatrix} I_0 \\ I_0 \\ I_0 \end{pmatrix}. \quad (1)$$

Dabei stehen $\hat{I}_A$, $\hat{I}_B$, $\hat{I}_C$ für die nullsystemstromkorrigierten Strommesswerte der Oberspannungsseite 10a; $I_0$ bezeichnet den Nullsystemstrom.

Der Nullsystemstrom $I_0$ kann dabei z.B. rechnerisch aus den Strommesswerten $I_A$, $I_B$, $I_C$ ermittelt werden:

$$3I_0 = I_A + I_B + I_C.$$

Alternativ kann der Nullsystemstrom auch aus der Messung des Sternpunktstroms $I_{St}$ bei Vorhandensein einer entsprechenden Messeinrichtung im Strompfad zwischen Sternpunkt 14 und Erde ermittelt und an das Differentialschutzgerät 11 übermittelt werden (in Figur 1 nicht dargestellt).

Die amplituden- und phasenwinkelangepassten Strommesswerte $I'_a$, $I'_b$, $I'_c$ der Niederspanungsseite 10b können nun gemeinsam mit den auf der Oberspannungsseite 10a erfassten und nullstromkorrigierten Strommesswerten $\hat{I}_A$, $\hat{I}_B$, $\hat{I}_C$ für den Differentialschutzvergleich herangezogen werden. Dabei wird unter Bildung eines jeweiligen Differenzstromwertes $I_{Dif}$ die Differenz aus den Beträgen jeweils zu einer Phase gehörender Strommesswerte gebildet:

$$I_{Dif,A} = |\hat{I}_A - I'_a|,$$

$$I_{Dif,B} = |\hat{I}_B - I'_b|,$$

$$I_{Dif,C} = |\hat{I}_C - I'_c|.$$

Um das Differentialschutzverfahren dynamisch an die Höhe des jeweils fließenden Stroms anzupassen und etwaige Wandlerfehler der verwendeten Strommesseinrichtungen auszugleichen, wird zudem aus den nullsystemstromkorrigierten bzw. amplituden- und phasenwinkelangepassten Strommesswerten $\hat{I}_A$, $\hat{I}_B$, $\hat{I}_C$ und $I'_a$, $I'_b$, $I'_c$ für jede Phase ein Stabilisierungswert $I_{Stab}$ gebildet. Der ggf. aufgrund von Wandlerfehlern fälschlicherweise ermittelte Differenzstromwert $I_{Dif}$ steigt nämlich proportional mit dem durch den Transformator fließenden Durchgangsstrom an und kann bei externen Kurzschlussströmen mit Wandlersättigung derart stark ansteigen, dass es ohne Stabilisierung zu einer Auslösung kommen würde, obwohl der Fehler nicht im Schutzbereich, also innerhalb des Transformators 10, liegt.

Anhand des berechneten Differenzstromwertes $I_{Dif}$ und des zugehörigen Stabilisierungswertes $I_{Stab}$ wird für jede Phase die Lage eines Messwertpaares aus Differenzstromwert $I_{Dif}$ und Stabilisierungswert $I_{Stab}$ in einem Auslösediagramm geprüft. Sofern das Messwertpaar mindestens einer Phase des Transformators 10 innerhalb eines Auslösegebietes liegt, wird ein einen Fehler angebendes Fehlersignal erzeugt, das von dem Differentialschutzgerät 11 zur Bildung eines Auslösesignals TRIP für einen (in Figur 1 nicht dargestellten) Leistungsschalter verwendet werden kann, um weitere Beschädigungen des Transformators 10 zu verhindern. Das Auslösesignal TRIP veranlasst den Leistungsschalter zum Öffnen entsprechender Schaltkontakte, um den Transformator 10 vom restlichen Energieversorgungsnetz abzutrennen. In herkömmlichen Ansätzen wurde der Stabilisierungswert $I_{Stab}$ bei Transformatoren entweder als Summe der Beträge der entsprechend nullsystemstromkorrigierten bzw. angepassten Strommesswerte

$$I_{Stab,A} = |\hat{I}_A| + |I'_a|,$$

als Betrag der Differenz der entsprechend nullsystemstromkorrigierten bzw. angepassten Strommesswerte

$$I_{Stab,A} = |\hat{I}_A - I'_a|,$$

oder als Maximalwert aus den entsprechend nullsystemstromkorrigierten bzw. angepassten Strommesswerten

$$I_{Stab,A} = \mathrm{Max}(|\hat{I}_A|;|I'_a|)$$

bestimmt. Die voranstehenden Gleichungen sind beispielhaft jeweils für die Phase A des Transformators 10 formuliert, die Gleichungen zur Berechnung der Stabilisierungswerte $I_{Stab,B}$ und $I_{Stab,C}$ für die beiden anderen Phasen B, C sind entsprechend aufzustellen.

Bei einer solchen herkömmlichen Bildung des Stabilisierungswertes haben sich jedoch Schwächen in Bezug auf die Nullstrombehandlung bei geerdetem Sternpunkt bei stromstarken externen Fehlern und ggf. auftretender Wandlersättigung ergeben. In Figur 1 ist ein solcher externer, d.h. außerhalb des Transformators liegender, Fehler zwischen Phase A und Erde an der Fehlerstelle F auf der Leitungsstrecke zwischen einem Generator 15 und dem Transformator 10 dargestellt. Dieser externe Fehler muss vom Differentialschutzgerät 11 als solcher erkannt werden und darf nicht zu einer ungewollten Auslösung führen.

Bei dem dargestellten externen einpoligen Fehler mit Erdberührung und Speisung über den geerdeten Transformator, fließt durch den Transformatorsternpunkt 14 als Nullsystemstrom $I_0$ der Kurzschlussstrom $-I_{KA}$ (der fließende Kurzschlussstrom ist in Figur 1 durch Pfeile angedeutet; die Höhe des jeweils fließenden Kurzschlussstroms wird durch die Anzahl von Pfeilen angedeutet, wobei mehr Pfeile für einen höheren Kurzschlussstrom stehen). Der Kurzschlussstrom bildet sich auf der Oberspannungsseite 10a des Transformators 10 in allen drei Phasen A, B, C gleichmäßig ab. Der Nullsystemstrom $I_0$ bildet sich hingegen nicht auf der Niederspannungsseite 10b des Transformators 10 ab, da diese als Dreieckswicklung ausgeführt ist. Deshalb wird im Transformatordifferentialschutz vor der Bildung des Differenzstromwertes $I_{Dif}$ und des Stabilisierungswertes $I_{Stab}$ die oben erläuterte eine Nullsystemstromkorrektur hinsichtlich derjenigen Seiten des Transformators 10 durchgeführt, die eine Erdung aufweisen (im vorliegenden Beispiel ist das lediglich die Oberspannungsseite 10a).

Bezogen auf den einpoligen Fehler in Figur 1 ist der Fehlerstrom auf der Oberspannungsseite 10a in allen drei Phasen hinsichtlich Amplitude und Phasenwinkel gleich groß. Somit gilt für die Oberspannungsseite 10b im Leerlauf des Transformators 10 also:

$$I_A = I_B = I_C = \frac{1}{3} I_{kA}$$

und

$$3I_0 = -I_{kA} \; .$$

Die nullstrombehandelten Strommesswerte der Oberspannungsseite 10a ergeben sich somit entsprechend der Gleichung (1) zu:

$$\begin{pmatrix} \hat{I}_A \\ \hat{I}_B \\ \hat{I}_C \end{pmatrix} = \begin{pmatrix} 1 & 0 & 0 \\ 0 & 1 & 0 \\ 0 & 0 & 1 \end{pmatrix} \cdot \begin{pmatrix} \frac{1}{3} I_{kA} \\ \frac{1}{3} I_{kA} \\ \frac{1}{3} I_{kA} \end{pmatrix} - \frac{1}{3} \begin{pmatrix} I_{kA} \\ I_{kA} \\ I_{kA} \end{pmatrix} = \begin{pmatrix} 0 \\ 0 \\ 0 \end{pmatrix} \; .$$

Wie man aus der voranstehenden Gleichung erkennt, werden die nullstrombehandelten Strommesswerte auf der Oberspannungsseite 10a, wenn man nur den Kurzschlussstrom $I_{kA}$ betrachtet, d.h. ohne Berücksichtigung des Laststroms, zu Null. Die oben genannten herkömmlichen Berechnungsverfahren für die Stabilisierungswerte führen somit zu Stabilisierungswerten, die nur den Laststrom auf der Niederspannungsseite 10b des Transformators 10 berücksichtigen. Im Leerlauf des Transformators kann ein solcher Laststrom ebenfalls Null betragen, so dass insgesamt ein Stabilisierungswert von Null (bzw. nahe Null) ermittelt wird.

Falls ein Leiterstromwandler den Strom nicht genau überträgt (z.B. bei Wandlersättigung, aber auch durch Messungenauigkeiten), wird der Falschanteil im bisherigen Verfahren mit gleichen Anteilen im Differenzstromwert und im Stabilisierungswert abgebildet. Dieses Verhältnis von annähernd 1 bildet sich im Auslösediagramm als Fehlerkennlinie beim inneren Fehler bei einseitiger Einspeisung ab und es kommt zur Fehlauslösung. Dieser Fall ist im Auslösediagramm in Figur 2 beispielhaft dargestellt, das der Einfachheit halber (wie die nachfolgenden Auslösediagramme in Figuren 3 und 4) lediglich für eine Phase, beispielsweise die Phase A, gezeigt ist. IM Auslösediagramm werden Messwertpaare aus ermittelten Differenzstromwerten und zugehörigen Stabilisierungswerten hinsichtlich ihrer Lage überprüft. Man erkennt die Fehlerkennlinie 20 als Diagonale im Auslösediagramm. Die Auslösekennlinie 21 trennt den Auslösebereich 23 vom Normalbereich 24 ab. Das Messwertpaar 25 aus Differenzstromwert $I_{Dif1}$ und nach herkömmlicher Weise berechnetem Stabilisierungswert $I_{Stab1}$ liegt im Auslösebereich 24 und führt somit - trotz externem Fehler - zur Auslösung.

Zur Lösung dieses Problems wird vorgeschlagen, die Berechnung des Stabilisierungswertes zu verändern, indem der Stabilisierungswert auch unter Berücksichtigung eines vorhandenen Nullsystemstroms ermittelt wird. Der Stabilisierungswert wird erfindungsgemäß durch Auswahl des Maximalwerts aus den jeweiligen ggf. angepassten und/oder nullstromkorrigierten Strommesswerten für jede Phase sowie aus dem gemessenen oder berechneten Nullsystemstrom gebildet (nachfolgend beispielhaft für Phase A):

$$I_{Stab,A} = Max(|\hat{I}_A|;|I_{0,S1}|;|I`_a|;|I_{0,S2}|)$$

Dabei stehen $I_{0,S1}$ und $I_{0,S2}$ für die auf den jeweiligen Seiten (S1: Seite 1, vorliegend Oberspanungsseite 10a; S2: Seite 2, vorliegend Niederspanungsseite 10b) des Transformators berechneten bzw. gemessenen Nullsystemströme. Sofern - wie vorliegend für die Niederspannungsseite 10b - ein Nullsystemstrom nicht vorhanden ist, fällt dieser Term bei der Ermittlung des Stabilisierungswertes entsprechend weg; vorliegend geht folglich nur der Nullsystemstrom $I_{0,S1}$ auf der Oberspannungsseite in die Berechnung des Stabilisierungswertes ein. Der Stabilisierungswert wird für jede Phase separat ermittelt. Die Anzahl der verwendeten Seiten des Transformators mit auftretenden Nullströmen und daher nötiger Nullstromkorrektur, bestimmt auch die Anzahl der zur Bildung des Stabilisierungswertes zu betrachtenden Nullströme.

Durch die veränderte Ermittlung des Stabilisierungswertes geht in die Stabilisierung des Differentialschutzverfahrens nunmehr ein fehlerbedingt entstehender Nullsystemstrom direkt ein und wird bei der Auslösebereichsprüfung entsprechend berücksichtigt. Die dargestellte Lösung löst daher das Problem einer Fehlauslösung bei dem in Figur 1 dargestellten externen Fehler. Dies ist in Figur 3 beispielhaft dargestellt. Bei im Vergleich zum Auslösediagramm in Figur 2 gleichbleibendem Wert des Differenzstromwertes $I_{Dif1}$ geht in die Berechnung des Stabilisierungswertes $I_{Stab}$ nun der signifikant höhere Nullsystemstrom ein. Hierdurch wird anstelle des im Fall der Figur 2 verwendeten Stabilisierungswertes $I_{Stab1}$ nunmehr der höhere Wert $I_{Stab2}$ verwendet; das Messwertpaar 31 aus $I_{Dif1}$ und $I_{Stab2}$ liegt im Normalbereich 24. Entsprechend wird von dem Differentialschutzgerät 11 für den externen Fehler keine Auslösung veranlasst.

Figur 4 zeigt beispielhaft den (in Figur 1 nicht dargestellten) Fall eines internen Fehlers. Aufgrund des nun höheren Differenzstromwertes $I_{Dif2}$ fällt das Messwertpaar 41 aus $I_{Dif2}$ und $I_{Stab2}$ in den Auslösebereich 23. Das Differentialschutzgerät 11 veranlasst entsprechend eine Auslösung eines Leistungsschalters zur Abschaltung des internen Fehlers.

Die beschriebene Lösung erlaubt in vorteilhafter Weise die Beibehaltung der bisherigen, bewährten Grundprinzipien des Standardstromdifferentialschutzes mit den gleichen Einstellungen für die Auslösekennlinie 21, so dass diesbezüglich keine veränderten Einstellungen vorgenommen werden müssen. Die Bildung des Differenzstromwertes $I_{Dif}$ wird ebenfalls nicht geändert. Eine Veränderung findet lediglich bei der Art der Bildung des Stabilisierungswertes $I_{Stab}$ statt. Dies ist auch wichtig, um eine Überstabilisierung bei internen Fehlern und eine damit einhergehende Unterfunktion zu vermeiden. Gleichzeitig wird jedoch eine verbesserte Stabilisierung bei externen Fehlern erreicht.

## Patentansprüche

**1.** Differentialschutzverfahren zum Erzeugen eines Fehlersignals, bei dem

- an mindestens zwei unterschiedlichen Messstellen (M1, M2) eines mehrphasigen Transformators (10) für jede Phase (A, B, C) jeweils Strommesswerte gemessen werden;
- mit den Strommesswerten für jede Phase (A, B, C) Differenzstromwerte und Stabilisierungswerte gebildet werden; und

- das Fehlersignal erzeugt wird, wenn im Rahmen einer Auslösebereichsprüfung festgestellt wird, dass ein unter Heranziehung eines der Differenzstromwerte und dem jeweils zugehörigen Stabilisierungswert gebildetes Messwertpaar zumindest einer der Phasen (A, B, C) in einem vorgegebenen Auslösebereich (23) liegt;
**dadurch gekennzeichnet, dass**
- der Transformator (10) einen geerdeten Sternpunkt (14) aufweist; und
- zur Bildung der Stabilisierungswerte ein durch den Sternpunkt (14) fließender Nullsystemstrom herangezogen wird, wobei als jeweiliger Stabilisierungswert ein Maximalwert aus den an den jeweiligen Messstellen (M1, M2) gebildeten Strommesswerten sowie den auf den jeweiligen Seiten (10a, 10b) des Transformators (10) fließenden Nullsystemströmen verwendet wird.

**2.** Differentialschutzverfahren nach Anspruch 1,
**dadurch gekennzeichnet, dass**

- der Nullsystemstrom durch Messung eines durch den Sternpunkt (14) fließenden Stroms ermittelt wird.

**3.** Differentialschutzverfahren nach Anspruch 1,
**dadurch gekennzeichnet, dass**

- der Nullsystemstrom rechnerisch aus den für die einzelnen Phasen (A, B, C) erfassten Strommesswerten ermittelt wird.

**4.** Elektrisches Differentialschutzgerät (11) zur Bildung eines Fehlersignals

- mit Anschlüssen zum unmittelbaren oder mittelbaren Anschluss an zumindest zwei unterschiedliche Messstellen (M1, M2) eines mehrphasigen Transformators (10), und
- mit einer Auswerteinrichtung (13), die dazu eingerichtet ist, mit an den Messstellen (M1, M2) erfassten Strommesswerten Differenzstromwerte und Stabilisierungswerte zu bilden und ein Fehlersignal zu erzeugen, wenn ein unter Heranziehung eines der Differenzstromwerte und dem jeweils zugehörigen Stabilisierungswert gebildetes Messwertpaar in einem vorgegebenen Auslösebereich (23) liegt,
**dadurch gekennzeichnet, dass**
- der Transformator (10) einen geerdeten Sternpunkt (14) aufweist; und
- die Auswerteinrichtung (13) dazu eingerichtet ist, zur Bildung der Stabilisierungswerte einen durch den Sternpunkt (14) fließenden Nullsystemstrom heranzuziehen, wobei die Auswerteinrichtung (13) dazu eingerichtet ist, den jeweiligen Stabilisierungswert durch Maximalwertermittlung aus den an den jeweiligen Messstellen (M1, M2) gebildeten Strommesswerten sowie den auf den jeweiligen Seiten (10a, 10b) des Transformators (10) fließenden Nullsystemströmen zu ermitteln.

**5.** Elektrisches Differentialschutzgerät (11) nach Anspruch 4, **dadurch gekennzeichnet, dass**

- das Differentialschutzgerät (11) einen Anschluss zum unmittelbaren oder mittelbaren Anschluss an einer Sternpunktstrommessstelle umfasst; und
- die Auswerteinrichtung dazu eingerichtet ist, den Nullsystemstrom durch Messung eines durch den Sternpunkt (14) fließenden Stroms zu ermitteln.

**6.** Elektrisches Differentialschutzgerät (11) nach Anspruch 4, **dadurch gekennzeichnet, dass**

- die Auswerteinrichtung (13) dazu eingerichtet ist, den Nullsystemstrom rechnerisch aus den für die einzelnen Phasen (A, B, C) erfassten Strommesswerten zu ermitteln.

## Claims

**1.** Differential protection method for generating a fault signal, in which

- current measurements are respectively measured at at least two different measuring points (M1, M2) of a multiphase transformer (10) for each phase (A, B, C);
- differential current values and stabilization values are formed with the current measurements for each phase (A, B, C); and

- the fault signal is generated if it is determined during a trigger region check that a pair of measurements, created with the aid of one of the differential current values and the respectively associated stabilization value, of at least one of the phases (A, B, C) lies in a predefined trigger region (23); **characterized in that**
- the transformer (10) has a grounded star point (14); and
- a zero system current flowing through the star point (14) is used for the formation of the stabilization values, wherein a maximum value from the current measurements formed at the respective measuring points (M1, M2) and the zero system currents flowing on the respective sides (10a, 10b) of the transformer (10) is used as the respective stabilization value.

**2.** Differential protection method according to Claim 1, **characterized in that**

- the zero system current is determined by measuring a current flowing through the star point (14).

**3.** Differential protection method according to Claim 1, **characterized in that**

- the zero system current is determined computationally from the current measurements acquired for the individual phases (A, B, C).

**4.** Electrical differential protection device (11) for forming a fault signal

- with terminals for direct or indirect connection to at least two different measuring points (M1, M2) of a multiphase transformer (10), and
- with an evaluation device (13) which is designed to form differential current values and stabilization values using current measurements acquired at the measuring points (M1, M2), and to generate a fault signal if a pair of measurements, formed using one of the differential current values and the respectively associated stabilization value, lies in a predefined trigger region (23),
**characterized in that**
- the transformer (10) has a grounded star point (14); and
- the evaluation device (13) is designed to use a zero system current flowing through the star point (14) to form the stabilization values, wherein the evaluation device (13) is designed to determine the respective stabilization value through determining the maximum value from the current measurements formed at the respective measuring points (M1, M2) and the zero system currents flowing on the respective sides (10a, 10b) of the transformer (10).

**5.** Electrical differential protection device (11) according to Claim 4,
**characterized in that**

- the differential protection device (11) comprises a terminal for the direct or indirect connection to a star point current measuring point; and
- the evaluation device is designed to determine the zero system current through measurement of a current flowing through the star point (14).

**6.** Electrical differential protection device (11) according to Claim 4,
**characterized in that**

- the evaluation device (13) is designed to determine the zero system current computationally from the current measurements acquired for the individual phases (A, B, C).

## Revendications

**1.** Procédé de protection différentielle pour produire un signal de défaut, dans lequel

- en au moins deux points (M1, M2) de mesure différents d'un transformateur (10) polyphasé, on mesure respectivement des valeurs de mesure de courant pour chaque phase (A, B, C) ;
- on forme, avec les valeurs de mesure de courant pour chaque phase (A, B, C), des valeurs de courant de différence et des valeurs de stabilisation ; et
- on produit le signal de défaut, si, dans le cadre d'un contrôle d'une plage de déclenchement, on constate qu'une paire de valeurs de mesure formée en tirant parti de l'une des valeurs de courant de mesure et de la valeur de stabilisation associée respectivement, au moins de l'une des phases (A, B, C), est dans une plage (23) de déclenchement donnée à l'avance ;
**caractérisé en ce que**
- le transformateur (10) a un point (14) neutre mis à la terre ; et
- pour former les valeurs de stabilisation, on tire parti du courant de système homopolaire passant par le point (14) neutre, en utilisant comme valeur de stabilisation respective une valeur maximum à partir des valeurs de mesure de courant formées aux points (M1, M2) respectifs, ainsi que des courants de système homopolaire passant sur les côtés (10a, 10b) respectifs du transformateur (10).

**2.** Procédé de protection différentielle suivant la revendication 1,
**caractérisé en ce que**

- on détermine le courant de système homopolaire en mesurant un courant passant par le point (14) neutre.

**3.** Procédé de protection différentielle suivant la revendication 1,
**caractérisé en ce que**

- on détermine le courant de système homopolaire par le calcul à partir des valeurs de mesure de courant relevées pour les diverses phases (A, B, C).

**4.** Appareil (11) électrique de protection différentielle pour former un signal de défaut

- comprenant des bornes pour la connexion directe ou indirecte à au moins deux points (M1, M2) de mesure différents d'un transformateur (10) polyphasé, et
- comprenant un dispositif (13) d'exploitation conçu pour former, avec des valeurs de mesure de courant relevées aux points (M1, M2) de mesure, des valeurs de courant de différence et des valeurs de stabilisation et pour produire un signal de défaut, si une paire de valeurs de mesure, formées en tirant parti de l'une des valeurs de courant de différence et de la valeur de la stabilisation associée respectivement, est dans une plage (23) de déclenchement donnée à l'avance, **caractérisé en ce que**
- le transformateur (10) a un point (14) neutre mis à la terre ; et
- le dispositif (13) d'exploitation est conçu pour tirer parti, pour la formation des valeurs de stabilisation, d'un courant de système homopolaire passant par le point (14) neutre, le dispositif (13) d'exploitation étant conçu pour déterminer la valeur de stabilisation respective en déterminant une valeur maximum à partir des valeurs de courant formées aux points (M1, M2) de mesure respectifs, ainsi que des courants de système homopolaire passant sur les côtés (10a, 10b) respectifs du transformateur (10).

**5.** Appareil (11) électrique de protection différentielle suivant la revendication 4,
**caractérisé en ce que**

- l'appareil (11) de protection différentielle comprend une borne de connexion directe ou indirecte à un point de mesure de courant de point neutre ; et
- le dispositif d'exploitation est conçu pour déterminer le courant de système homopolaire en mesurant un courant passant dans le point (14) neutre.

**6.** Appareil (11) électrique de protection différentielle suivant la revendication 4,
**caractérisé en ce que**

- le dispositif (13) d'exploitation est conçu pour déterminer le courant de système homopolaire par le calcul à partir des valeurs de mesure de courant relevées pour les diverses phases (A, B, C).

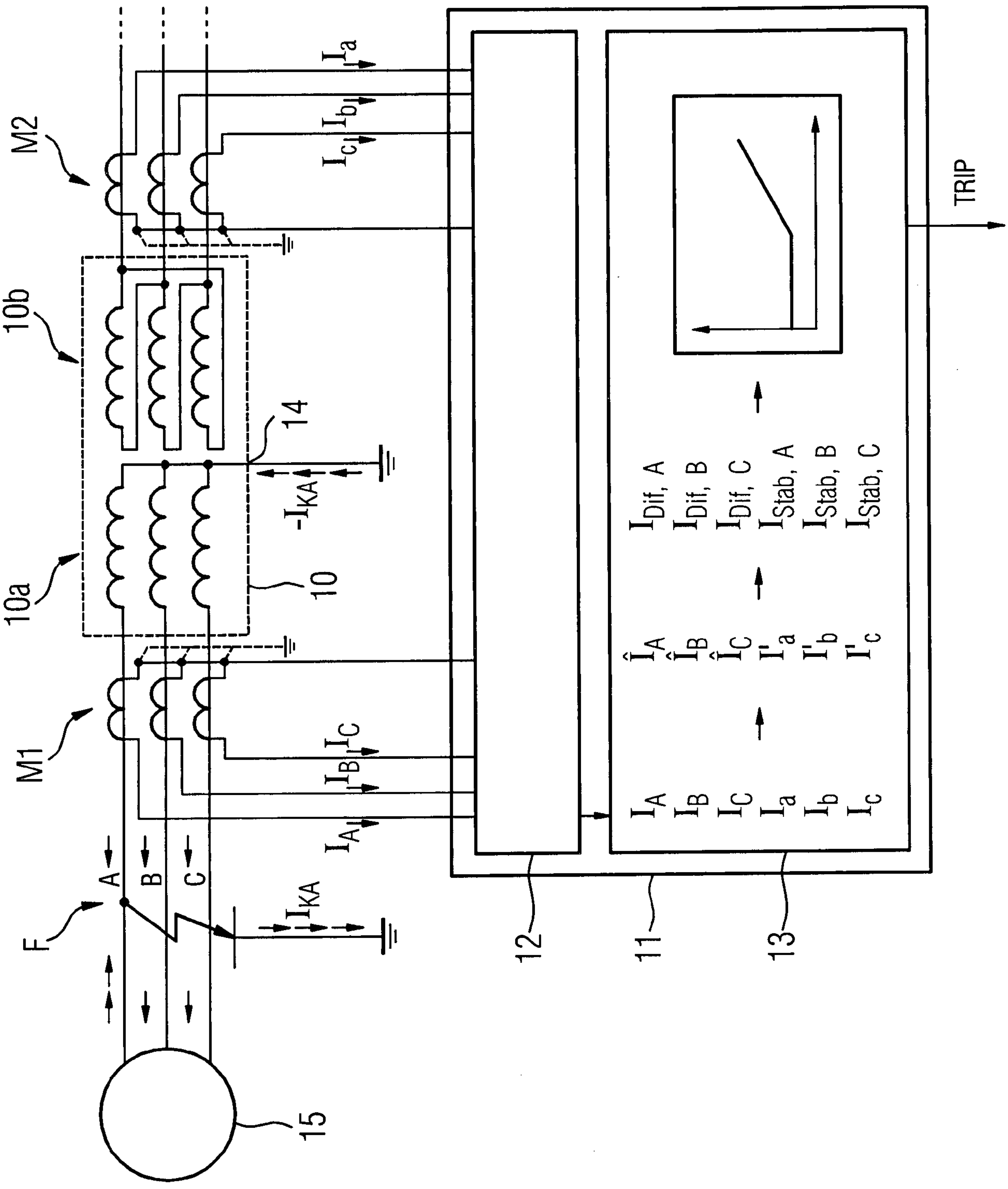
M2
10b
10a
M1
F
A
B
C
14
10
15
12
11
13
$I_a$
$I_b$
$I_c$
$I_A$
$I_B$
$I_C$
$I_{KA}$
$-I_{KA}$
TRIP
$I_A$ $I_B$ $I_C$ $I_a$ $I_b$ $I_c$
$\hat{I}_A$ $\hat{I}_B$ $\hat{I}_C$ $I'_a$ $I'_b$ $I'_c$
$I_{Dif, A}$ $I_{Dif, B}$ $I_{Dif, C}$ $I_{Stab, A}$ $I_{Stab, B}$ $I_{Stab, C}$

FIG 1

FIG 2

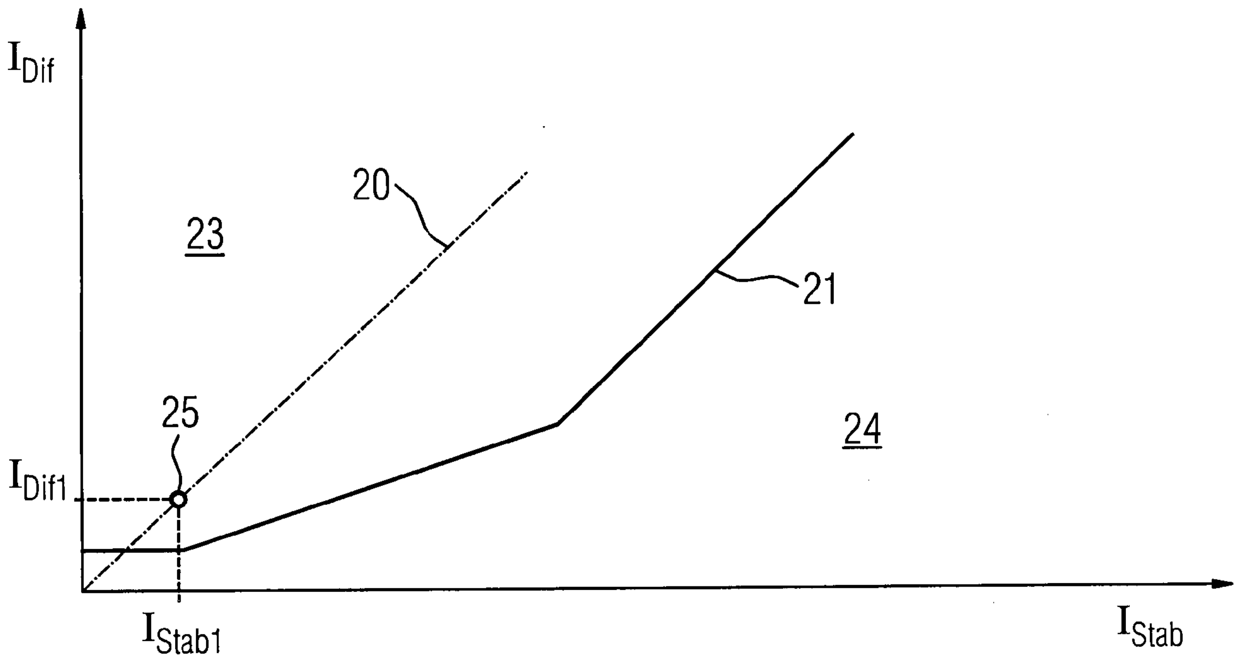
$I_{Dif}$
20
23
21
25
24
$I_{Dif1}$
$I_{Stab1}$
$I_{Stab}$

FIG 3

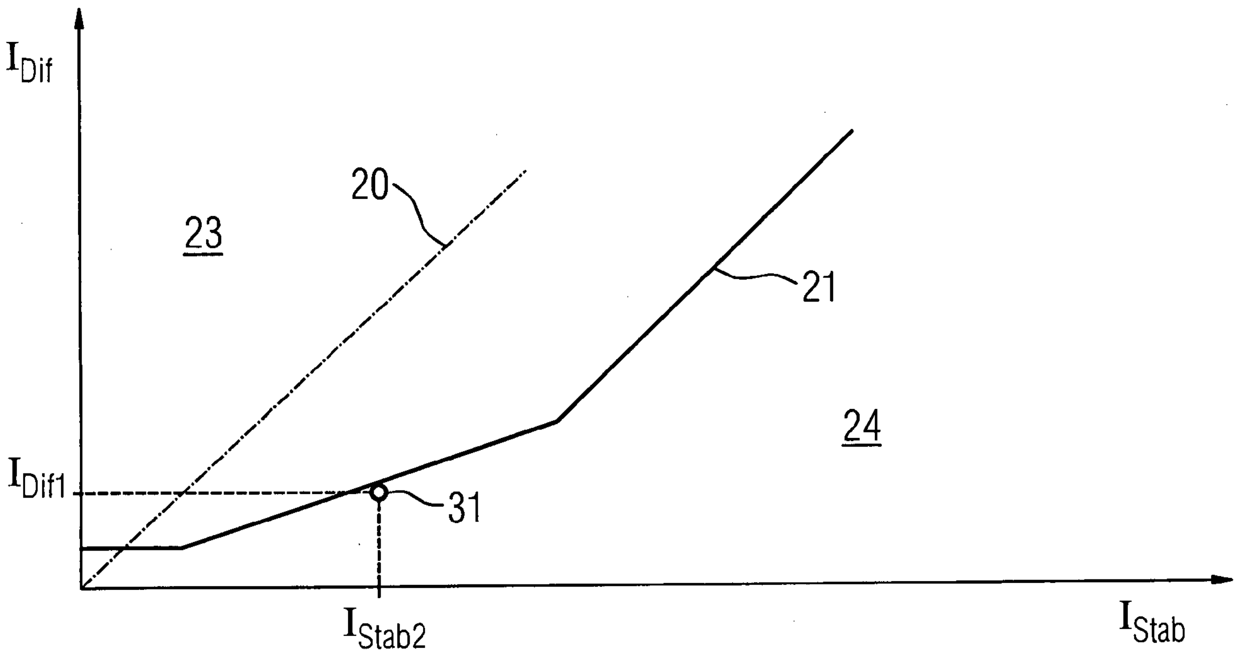
$I_{Dif}$
20
23
21
24
$I_{Dif1}$
31
$I_{Stab2}$
$I_{Stab}$

FIG 4

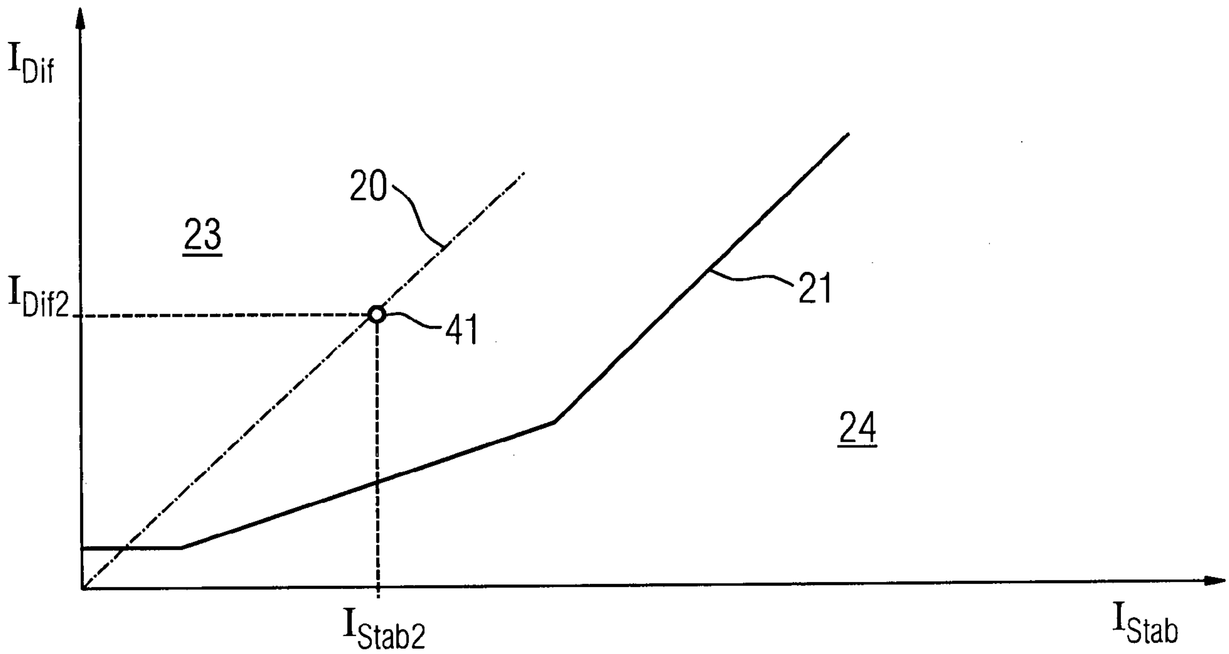

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2008025309 A1
- WO 2014079511 A1
- DE 4416048 C1